# EUROPÄISCHE PATENTSCHRIFT

(11) **EP 4 213 202 B1**
(45) Veröffentlichungstag und Bekanntmachung des Hinweises auf die Patenterteilung: **28.02.2024**
(21) Anmeldenummer: 22151767.5
(22) Anmeldetag: 17.01.2022
(51) Int. Cl.: H01L 23/40, H05K 7/20, H05K 7/14

(54) **LEISTUNGSMODUL**
POWER MODULE
MODULE DE PUISSANCE

(43) Veröffentlichungstag der Anmeldung: 19.07.2023
(73) Patentinhaber: Siemens Aktiengesellschaft, 80333 München (DE)
(72) Erfinder: Kögler, Roman, 90403 Nürnberg (DE); Roppelt, Bernd, 96173 Unterhaid (DE); Schmenger, Jens, 91301 Forchheim (DE); Schwinn, Thomas, 91074 Herzogenaurach (DE)
(74) Vertreter: Siemens Patent Attorneys

(56) Entgegenhaltungen:
- EP-A1- 2 395 647
- EP-A1- 2 467 001
- WO-A1-2022/002464
- DE-B3-102013 100 700
- US-A1- 2017 316 992

## Beschreibung

Die Erfindung betrifft ein Leistungsmodul mit wenigstens einem Kühlkörper und wenigstens einer Leistungseinheit, wobei die Leistungseinheit wenigstens ein Halbleiterbauelement und ein Substrat umfasst.

Eine genaue Ausrichtung der Leistungseinheit zu einer Ansteuerungseinheit, insbesondere Leiterplatte, ist schwierig. Ungenauigkeiten führen dazu, dass Pins nicht richtig positioniert werden können und so die Funktionalität des Leistungsmoduls nicht oder zumindest nicht vollständig gegeben ist.

Die Offenlegungsschrift DE 10 2013 100700 B3 beschreibt ein Leistungsmodul gemäß dem Stand der Technik.

Der Erfindung liegt die Aufgabe zugrunde, eine Positionierung der Ansteuerungseinheit bezüglich der Leistungseinheit zu vereinfachen und zu verbessern.

Die Lösung der Aufgabe gelingt durch Anspruch 1, d. h. ein Leistungsmodul, aufweisend:
- wenigstens einen Kühlkörper,
- wenigstens eine Leistungseinheit, wobei die Leistungseinheit wenigstens ein Halbleiterbauelement und ein Substrat umfasst,
- eine Vorrichtung zur Einfassung der wenigstens teilweise innerhalb und/oder auf dem Kühlkörper ausgebildeten Leistungseinheit und zur Zentrierung einer Ansteuerungseinheit bezüglich der Leistungseinheit, wobei die Vorrichtung umfasst:
- einen Rahmen, wobei der Rahmen das Substrat wenigstens teilweise, vorzugsweise vollständig, umgibt,
- wenigstens einen ersten vorstehenden Abschnitt, wobei der erste vorstehende Abschnitt in eine Vertiefung oder eine Öffnung des Kühlkörpers eingreift,
- wenigstens einen zweiten vorstehenden Abschnitt, wobei der zweite vorstehende Abschnitt zum Eingriff in eine Vertiefung oder eine Öffnung oder eine Einkerbung einer wenigstens ein elektronisches Bauelement aufweisenden Ansteuerungseinheit ausgebildet ist,
wobei eine Kontur des zweiten vorstehenden Abschnitts im Querschnitt betrachtet wenigstens im Wesentlichen in Form eines Sterns ausgebildet ist, wobei der Stern wenigstens einen ersten Schenkel, einen zweiten Schenkel und einen dritten Schenkel aufweist.

Vorteilhaft ist eine Ausführung, wonach eine Kontur des ersten vorstehenden Abschnitts im Querschnitt betrachtet wenigstens im Wesentlichen in Form eines Kreises ausgebildet ist Die Kontur des ersten vorstehenden Abschnitts kann jedoch auch beispielsweise sternförmig oder kreuzförmig sein. Auch andere Formen sind denkbar.

Die Vorrichtung ist vorzugsweise einteilig.

Das Substrat fungiert vorteilhaft als Leitelement.

Das Substrat umfasst z. B. wenigstens eine elektrisch leitfähige Schicht, wobei die elektrisch leitfähige Schicht vorzugsweise Kupfer aufweist, und wenigstens eine thermisch leitfähige Schicht, wobei die thermisch leitfähige Schicht vorzugsweise Keramik aufweist.

Die thermisch leitfähige Schicht ist vorteilhaft elektrisch isolierend. Diese soll einerseits eine Isolation herstellen sowie andererseits Abwärme abführen. Keramik ist hierbei von Vorteil, da dadurch die Herstellung der elektrischen Isolation besonders gut gelingt.

Besonders vorteilhaft weist das Substrat drei Schichten auf. Eine erste Schicht, welche dem Kühlkörper zugewandt ist, weist vorzugsweise Kupfer auf. Eine zweite Schicht, die an die erste Schicht angrenzt, weist vorzugsweise Keramik auf. Eine dritte Schicht, die an die zweite Schicht angrenzt, weist vorzugsweise Kupfer auf. Die erste und die dritte Schicht sind somit elektrisch leitfähige Schichten, die zweite Schicht ist somit eine thermisch leitfähige Schicht. Die thermisch leitfähige Schicht ist vorteilhaft elektrisch isolierend.

Das Leitelement umfasst vorzugsweise an und/oder auf der dritten Schicht wenigstens ein Halbleiterbauelement, vorzugsweise eine Mehrzahl an Halbleiterbauelementen.

Die Leistungseinheit ist vorzugsweise Teil eines Umrichtersystems bzw. Stromrichtersystems.

Die Vorrichtung ersetzt das bisherige Gehäuse und ist hierbei konstruktiv stark vereinfacht. Zudem ist durch die Erfindung auch eine Baugrößenreduzierung bei ausreichender und gleichmäßiger Kühlung möglich.

Die sternförmige Kontur kann auch als Y-förmige Kontur angesehen werden.

Drei Schenkel sind besonders vorteilhaft, da hierbei eine hohe Stabilität bei nur geringem Materialeinsatz gewährleistet wird. Im Gegensatz zu einem beispielhaften zweiten vorstehenden Abschnitt, welcher als Dom oder Kegel oder Zylinder ausgebildet ist, ist der Materialeinsatz deutlich reduziert.

Für eine hohe Temperaturbeständigkeit wird vorteilhaft ein Kunststoff bzw. Harz mit einem hohen Glasfaseranteil verwendet, was sehr kostenintensiv ist. Auch nur eine geringe Materialreduktion verringert hierbei die Kosten.

Die Kontur bietet zudem den Vorteil, dass keine Versteifungen zum Stabilisieren benötigt werden, die andererseits insbesondere durch Materialschwund beim Abkühlen eines gegossenen oder gespritzten Rahmens benötigt würden.

Durch die sternförmige Kontur ist der zweite vorstehende Abschnitt versteift, insbesondere in Richtung der Ansteuerungseinheit. Dadurch ist der zweite vorstehende Abschnitt besonders stabil und neigt weniger zu einem Schiefstand. Ein Schiefstand sollte vermieden werden, da dieser zu Ausschuss bei einem Fügevorgang des Leistungsmoduls mit der Ansteuerungseinheit führt.

Die sternförmige Kontur ist auch hinsichtlich der Werkzeugkosten von Vorteil. Z. B. wird bei einem zweiten vorstehenden Abschnitt, der als hohler Zylinder ausgebildet ist, im Werkzeug ein Stift benötigt, um welchen Material gespritzt wird. Auf diesen Stift kann infolge der sternförmigen Form verzichtet werden.

Durch die sternförmige Kontur ist eine Berührungsfläche zwischen dem zweiten vorstehenden Abschnitt und der Ansteuerungseinheit reduziert, wodurch eine beim Fügen auftretende Reibung verringert wird. Der Fügevorgang wird - im Vergleich zu einer runden Form - geschmeidiger, wenn nur drei Sternspitzen (also radial betrachtet die Enden der Schenkel) in Kontakt mit der Ansteuerungseinheit stehen.

Vorteilhaft ist eine Ausführungsform, wonach der erste Schenkel und der zweite Schenkel derart angeordnet sind, dass sie aus einer Vogelperspektive betrachtet die Kontur des ersten Abschnitts teilweise umgeben.

Dies ist eine besonders platzsparende Ausführungsform.

Vorteilhaft ist eine Ausführungsform, wonach eine Länge des ersten Schenkels einer Länge des zweiten Schenkels entspricht.

Besonders vorteilhaft ist eine Ausführung, wonach alle Schenkel gleich lang sind. So ist der vorstehende Abschnitt besonders stabil.

Vorteilhaft kann auch eine Ausführungsform sein, wonach der erste Schenkel länger ist als der dritte Schenkel.

Diese Ausführungsform kann auch zur platzsparenden Bauweise verwendet werden. Vorteilhaft ist der kürzeste Schenkel in diesem Fall in einer vom anderen Abschnitt wegweisenden Richtung ausgebildet.

Vorteilhaft ist eine Ausführungsform, wonach der Rahmen auf dem Kühlkörper mittels Klebung fixiert ist.

Da keine Verschraubung oder ähnliches benötigt wird, kann der Kühlkörper, insbesondere die Kühlkörperbasis, schlanker gestaltet werden. Auch so kann eine kompakte Bauweise des Leistungsmoduls erreicht werden.

Vorteilhaft ist eine Ausführung, wonach der Rahmen rechteckig ausgebildet ist, wobei der erste vorstehende Abschnitt wenigstens im Wesentlichen an einer Ecke, insbesondere Außenecke, des Rahmens angeordnet ist, wobei der zweite vorstehende Abschnitt wenigstens im Wesentlichen an einer Ecke, insbesondere Außenecke, des Rahmens angeordnet ist.

So kann gelingt eine Positionierung bzw. Zentrierung besonders gut.

Vorteilhaft ist eine Ausführungsform, wonach der erste vorstehende Abschnitt und der zweite vorstehende Abschnitt in gegensätzliche Richtungen ragend ausgebildet sind.

So gelingt eine gute Positionierung des Rahmens bezüglich des Kühlkörpers und zudem eine gute Positionierung der Ansteuerungseinheit bezüglich des Rahmens.

Vorteilhaft ist eine Ausführungsform, wonach der erste vorstehende Abschnitt und der zweite vorstehende Abschnitt senkrecht zu einer Oberfläche des Kühlkörpers ausgerichtet sind.

So gelingt ein Fügevorgang besonders gut.

Vorteilhaft ist eine Ausführungsform, wonach der Rahmen Polyphenylensulfid (PPS) aufweist.

PPS ist von Vorteil, da dies ein hochtemperaturbeständiger (z. B. bis zu 175°C freigegeben) thermoplastischer Kunststoff ist.

Vorteilhaft ist beispielsweise eine Ausführungsform, wonach der Rahmen Polyphenylensulfid mit einem Faseranteil von 50 % bis 75 %, insbesondere 60 % bis 65 %, aufweist.

Jedoch können auch andere Kunststoffe eingesetzt werden.

Vorteilhaft ist eine Ausführungsform, wonach ein Winkel zwischen dem ersten Schenkel und dem zweiten Schenkel einem Winkel zwischen dem zweiten Schenkel und dem dritten Schenkel gleicht.

Besonders vorteilhaft ist ein Stern mit um 120° gleichmäßig versetzte Schenkel. Durch diese spezielle Form können Formund Lagetoleranzen während des Positioniervorgangs besser ausgeglichen werden. Es ist bei gleichem ausgehenden Bohrungsdurchmesser in der Leiterplatte mehr Verdrehung des gesamten Leistungsmoduls möglich.

Vorteilhaft ist eine Ausführungsform, wonach ein Schenkel ein Breite aufweist, die zwischen 0,5 mm und 2 mm, vorzugsweise zwischen 0,8 mm und 1,6 mm, insbesondere zwischen 1,1 mm und 1,3 mm, liegt.

Aus Stabilitätsgründen sind z. B. 1,2 mm gut geeignet.

Vorteilhaft ist eine Ausführungsform, wonach das Leistungsmodul ferner ein Fixierungselement zur Fixierung der Ansteuerungseinheit aufweist.

So kann die Ansteuerungseinheit sicher fixiert werden. Das Fixierungselement ist z. B. eine Schraube (siehe auch Figurenbeschreibung) .

Die Lösung der Aufgabe gelingt zudem durch einen Rahmen für ein Leistungsmodul nach einem der vorhergehenden Ansprüche, aufweisend:
- wenigstens einen ersten vorstehenden Abschnitt, wobei der erste vorstehende Abschnitt zum Eingriff in eine Vertiefung oder eine Öffnung eines Kühlkörpers ausgebildet ist,
- wenigstens einen zweiten vorstehenden Abschnitt, wobei der zweite vorstehende Abschnitt zum Eingriff in eine Vertiefung oder eine Öffnung einer wenigstens ein elektronisches Bauelement aufweisenden Ansteuerungseinheit ausgebildet ist, wobei eine Kontur des zweiten vorstehenden Abschnitts im Querschnitt betrachtet wenigstens im Wesentlichen in Form eines Sterns ausgebildet ist, wobei der Stern wenigstens drei Schenkel aufweist.

Vorteilhaft ist eine Ausführung, wonach eine Kontur des ersten vorstehenden Abschnitts (3) im Querschnitt betrachtet wenigstens im Wesentlichen in Form eines Kreises (in anderen Worten: rund) ausgebildet ist,

Die Lösung der Aufgabe gelingt ferner durch einen Stromrichter, aufweisend:
- ein derartiges Leistungsmodul,
- eine wenigstens ein elektronisches Bauelement aufweisende Ansteuerungseinheit,
wobei das Leistungsmodul und die Ansteuerungseinheit miteinander verbunden sind.

Vorteilhaft ist hierbei eine Ausführungsform, wonach die Ansteuerungseinheit bezüglich des Leistungsmoduls durch einen Eingriff des zweiten vorstehenden Abschnitts des Leistungsmoduls in eine Vertiefung oder eine Öffnung der Ansteuerungseinheit zentriert ist.

Im Folgenden wird die Erfindung anhand der in Figuren dargestellten Ausführungsbeispiele näher beschrieben und erläutert. Es zeigen:
- FIG 1: eine mögliche Ausgestaltung eines Leistungsmoduls,
- FIG 2 und 9: eine Kontur eines zweiten vorstehenden Abschnitts im Detail,
- FIG 3: die mögliche Ausgestaltung aus FIG 1 in einer explodierten Ansicht,
- FIG 4 und 5: ein Leistungsmodul, welches mit einer Ansteuerungseinheit verbunden ist,
- FIG 6: einen Stromrichter,
- FIG 7: ein Leistungsmodul, welches mit einer Ansteuerungseinheit verbunden ist, aus der Vogelperspektive,
- FIG 8: einen Rahmen.

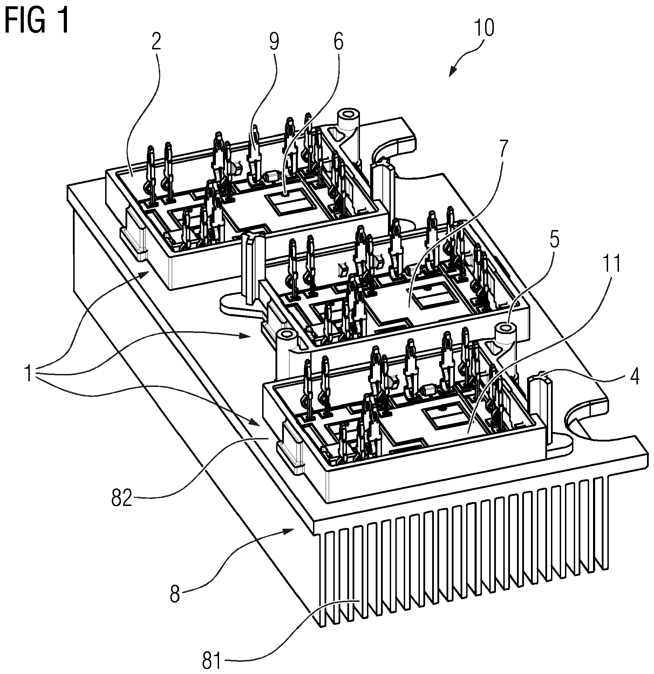

FIG 1 zeigt eine mögliche Ausgestaltung eines Leistungsmoduls 10, aufweisend eine Vorrichtung 1.

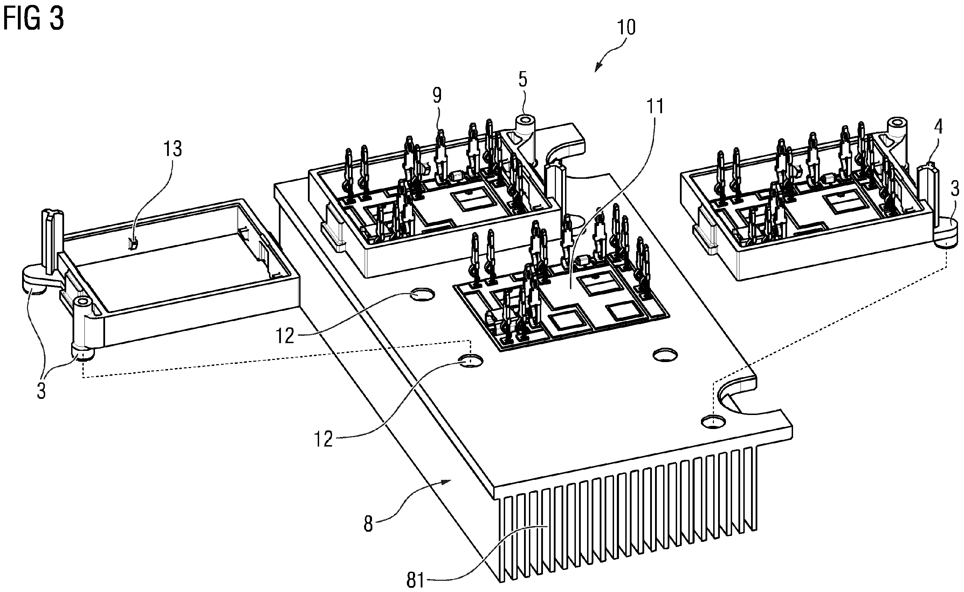

FIG 3 zeigt die mögliche Ausgestaltung aus FIG 1 in einer explodierten Ansicht.

Die Vorrichtung 1 fasst ein auf dem Leistungsmodul 10 ausgebildeten Leistungseinheit 11 ein.

Die Leistungseinheit 11 umfasst wenigstens ein Halbleiterbauelement 6. Dies ist insbesondere ein Leistungshalbleiter, z. B. IGBT. Die Leistungseinheit 11 umfasst ferner ein Substrat 7.

Die Vorrichtung 1 umfasst einen Rahmen 2, wobei der Rahmen 2 das Substrat 7 vollständig umgibt.

Die Vorrichtung 1 umfasst wenigstens einen ersten vorstehenden Abschnitt 3, wobei der erste vorstehende Abschnitt 3 in eine Vertiefung oder eine Öffnung 12 eines Kühlkörpers 8 eingreift (in der Figur) bzw. zum Eingriff in die Öffnung 12 ausgebildet ist.

Die Öffnung 12 kann z. B. eine Einkerbung, eine Vertiefung, ein Sackloch oder ein Loch sein.

Vorteilhaft ist die Öffnung 12 in einer Basis 22 (bzw. Grundplatte) des Kühlkörpers 8 ausgebildet.

Unterhalb der Basis 22 sind in der Figur Kühlrippen 81 angeordnet.

Der Kühlkörper 8 weist in der Figur eine Mehrzahl an Kühlrippen 81 auf. Die Kühlrippen 81 sind vorteilhaft parallel angeordnet.

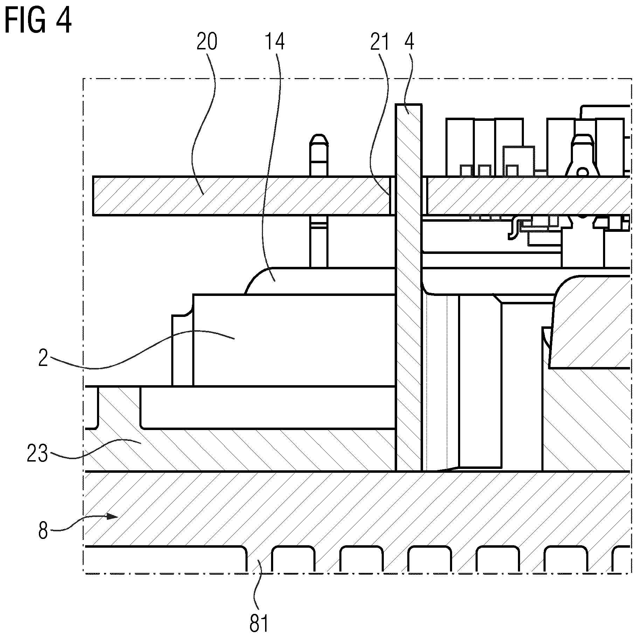

Die Vorrichtung 1 umfasst zudem wenigstens einen zweiten vorstehenden Abschnitt 4, wobei der zweite vorstehende Abschnitt 4 zum Eingriff in eine Einkerbung bzw. Vertiefung oder eine Öffnung 21 (siehe FIG 4), z. B. ein Loch, einer wenigstens ein elektronisches Bauelement aufweisende Ansteuerungseinheit 20 (siehe FIG 4) ausgebildet ist.

Die Ansteuerungseinheit 20 ist vorteilhaft eine Hauptplatine.

Die Figur zeigt zudem Kontaktierungselemente 9. Ein Kontaktierungselement ist vorzugsweise ein Pin. Vorteilhaft weist die Leistungseinheit 11 eine Mehrzahl an Kontaktierungselementen 9 auf. Die Kontaktierungselemente 9 können als Einzelpins ausgeführt sein oder als mehrteiliges Pinsystem.

Die Vorrichtung 1 weist in der Figur ein Fixierungselement 5 auf. Das Fixierungselement 5 ist zur Fixierung der Ansteuerungseinheit 20 ausgebildet.

Der Rahmen 2 ist in der Figur rechteckig ausgebildet. Jedoch sind auch andere Formen denkbar, wie beispielsweise ein runder Rahmen, ein ovaler Rahmen, ein quadratischer Rahmen oder ein trapezförmiger Rahmen.

FIG 1 und FIG 3 zeigen, dass der erste vorstehende Abschnitt 3 wenigstens im Wesentlichen an einer Außenecke bzw. im Bereich der Außenecke des Rahmens 2 angeordnet ist.

FIG 1 und FIG 3 zeigen zudem, dass der zweite vorstehende Abschnitt 4 wenigstens im Wesentlichen an einer Außeneckecke bzw. im Bereich der Außenecke des Rahmens 2 angeordnet ist.

Eine diagonale Anordnung zueinander ist zudem denkbar.

Vorteilhaft sind die beiden Abschnitte 3 und 4 an einer gemeinsamen Ecke des Rahmens 2 angeordnet. Die beiden Abschnitte 3 und 4 sind vorteilhaft stoffschlüssig miteinander verbunden. Sie sind vorteilhaft in gegensätzliche Richtungen ragend ausgebildet. Sie sind vorteilhaft einstückig.

Der erste vorstehende Abschnitt 3 ist vorteilhaft als Positionierzapfen ausgebildet.

Auf diese Weise gelingt eine genaue Positionierung der Vorrichtung 1 auf einer Oberfläche des Kühlkörpers 8. Vorteilhaft liegt hierbei keine form- und/oder kraftschlüssige Verbindung vor.

Eine Fixierung des Rahmens 2 auf dem Kühlkörper 8 gelingt z. B. mittels Klebung.

Das vorstehende Stück erster Art 3 weist vorteilhaft eine Form auf, die sich wenigstens im Wesentlichen passgenau in die Vertiefung 12 oder Öffnung des Kühlkörpers 8 einfügt.

Der erste vorstehende Abschnitt 3 weist vorteilhaft einen runden Querschnitt auf. Jedoch sind auch andere Formen denkbar.

Der vorstehende Abschnitt 4 ist vorteilhaft als Zentrierdom ausgebildet.

Eine Kontur des zweiten vorstehenden Abschnitts 4 ist, im Querschnitt betrachtet, wenigstens im Wesentlichen in Form eines Sterns ausgebildet, wobei der Stern wenigstens einen ersten Schenkel, einen zweiten Schenkel und einen dritten Schenkel aufweist.

Dies ermöglicht eine genaue Zentrierung der Ansteuerungseinheit. Es sind keine Führungswerkzeuge nötig.

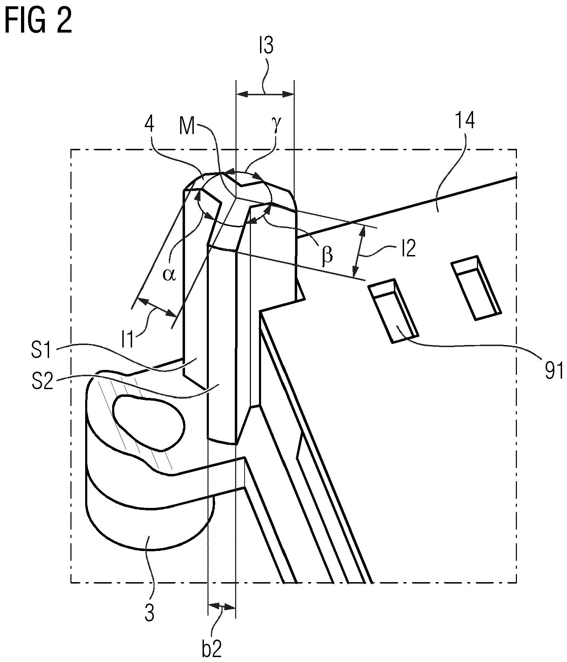

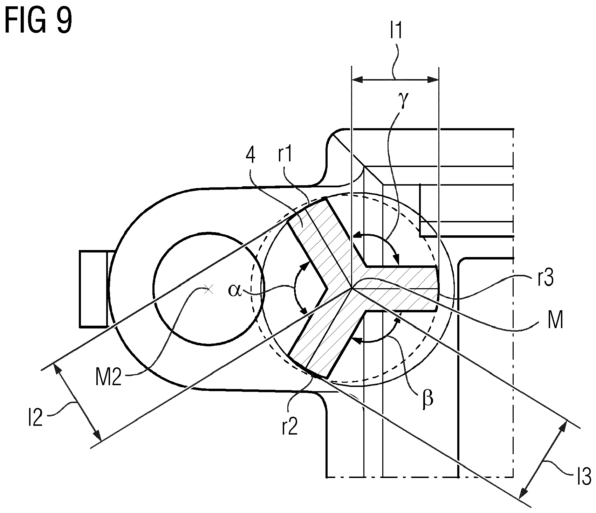

In FIG 2 und in FIG 9 sind die Konturen der Abschnitte 3 und 4 im Detail gezeigt.

Vorteilhaft weist der zweite vorstehende Abschnitt 4 genau drei Schenkel S1, S2 und S3 auf. Diese sind sternförmig (oder auch: Y-förmig) um einen Mittelpunkt M angeordnet.

Bezüglich des Mittelpunkts M gilt vorteilhaft: l1=l2=l3, wobei 11 eine Länge des ersten Schenkels S1 ist, wobei 12 eine Länge des zweiten Schenkels S2 ist, wobei 13 eine Länge des dritten Schenkels S3 ist.

Für 11 gilt vorteilhaft: 0,5 mm ≤ 11 ≤ 5 mm. Besonders bevorzugt gilt: 1,5 mm ≤ 11 ≤ 3,5 mm.

Eine besonders vorteilhafte Ausführungsform ist: : 2 mm ≤ 11 ≤ 3 mm, 11 ist beispielsweise 2,515 mm.

Alternativ ist auch denkbar, dass ein Schenkel länger als ein anderer ist.

Vorteilhaft sind die Schenkel S1, S2 und S3 derart angeordnet, dass für dazwischen liegende Winkel α, β und γ gilt: α = β = γ.

Beispielhaft wird eine Schenkelbreite b2 am Schenkel S2 gezeigt. Diese beträgt vorteilhaft zwischen 0,5 mm und 2 mm, vorzugsweise zwischen 0,8 mm und 1,6 mm, insbesondere zwischen 1,1 mm und 1,3 mm, liegt.

Aus Stabilitätsgründen sind z. B. 1,2 mm gut geeignet.

FIG 2 zeigt, dass der vorstehende Abschnitt 4 in eine seitliche Einkerbung eines Deckels 14 eingreift.

Ein Verdrehen wird durch die beschriebene Anordnung der Anschnitte 3 und 4 verhindert.

Zudem wird in FIG 2 gezeigt, dass der Deckel 14 Öffnungen 91 für Pins 9 (s. FIG 1) aufweist.

Der Rahmen 2 ist vorteilhaft derart ausgebildet, dass eine aufgebrachte Vergussmasse innerhalb eines Bereichs, der vom Rahmen 2 und dem Leistungsmodul 10 bzw. eine Seite des Leistungsmoduls 10 eingegrenzt ist, verbleibt.

Der Rahmen 2 ist hierzu vorteilhaft mit einer Oberfläche des Leistungsmoduls 10 stoffschlüssig, insbesondere mittels Klebung, verbunden.

Als Vergussmasse eignet sich besonders gut Silikon. Auch Polyurethan und/oder Epoxide sind denkbar.

Silikon ist hochtemperaturbeständig. Zudem erstarrt Silikon bei Raumtemperatur bzw. mittels UV-Licht.

Silikon besitzt überdies sehr gute elektrisch isolierende Eigenschaften und ist niedrig viskos und weist ein gutes Fließverhalten auf.

Die Leistungseinheit 11 ist vorteilhaft mit dem Kühlkörper 8 verbunden. Diese Verbindung gelingt vorzugsweise mittels Pressen und/oder Löten und/oder Sintern. Es sind jedoch auch andersartige Verbindungen, insbesondere eine Verbindung mittels anderer thermisch leitender Materialen, denkbar.

Zudem sind auch Verbindungen möglich, welche durch einen Eintrag thermischer Energie, z. B. Schweißen, gelingen.

Die Leistungseinheit 11 ist vorteilhaft als Teil eines moduleigenen Kühlkörper ausgebildet.

Die Leistungseinheit ist vorteilhaft als Direct Copper Bonded (auch DCB genannt) ausgeführt.

Der moduleigene Kühlkörper weist vorteilhaft die Leistungseinheit 11 sowie Kontaktierungselemente auf.

Ein Kühlkörper 8 weist vorteilhaft wenigstens eine Leistungseinheit 11 auf. Ein Kühlkörper 8 kann jedoch auch zwei oder mehr Leistungseinheiten 11 umfassen.

Optimal ist, wenn ein Kühlkörper 8 drei Leistungseinheiten 11 umfasst. Dies gewährleistet eine gute Kühlung bei einer optimalen Auslastung im Hinblick auf Leistung.

Drei Leistungseinheiten 11 sind vorteilhaft, da jeweils eine Leistungseinheit einer Phase eines dreiphasigen Systems zugeordnet werden kann.

Das Halbleiterbauelement 6 ist beispielsweise ein Thyristor oder ein MOSFET oder ein IGBT. Auch andere Halbleiterbauelemente sind denkbar.

Ist das Halbleiterbauelement 6 als IGBT ausgeführt, wird zudem eine Freilaufdiode benötigt. Es sind auch andere Halbleiterbauelemente denkbar.

Die Ansteuerungseinheit 20 ist vorzugsweise ein Power Board (auch Hauptplatine genannt), also eine Leiterplatte samt Bestückung mit Bauelementen, und dient vorzugsweise einer Ansteuerung sowie einer Energieversorgung, vorzugsweise mittels Gleichspannung.

FIG 3 zeigt zudem eine Vorrichtung, die zur Auflage eines Deckels ausgebildet ist. Die Vorrichtung weist beispielsweise eine Mehrzahl an Nasen 13 auf.

Der Deckel 14 ist in FIG 4 dargestellt. Der Deckel ermöglicht mitunter eine Führung der Pins 9. Der Deckel kann hierzu Aussparungen aufweisen.

Zudem bietet der Deckel 14 Schutz bei Explosionen. Bei Leistungstests werden die Halbleiterbauelemente derart gefordert bzw. überlastet, dass es zu Explosionen kommen kann. Der Deckel dient dem Umgebungsschutz, insbesondere dem Schutz des Umrichters bzw. Stromrichters.

Der Deckel weist hierzu beispielsweise glasfaserverstärktes Polycarbonat auf.

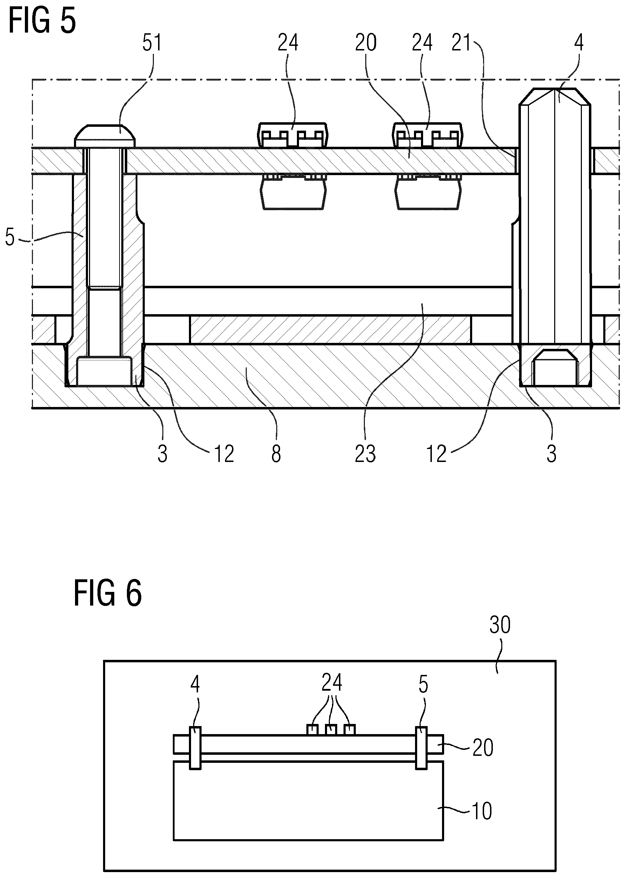

FIG 4 und FIG 5 zeigen das Leistungsmodul 10, welches mit der Ansteuerungseinheit 20 verbunden ist.

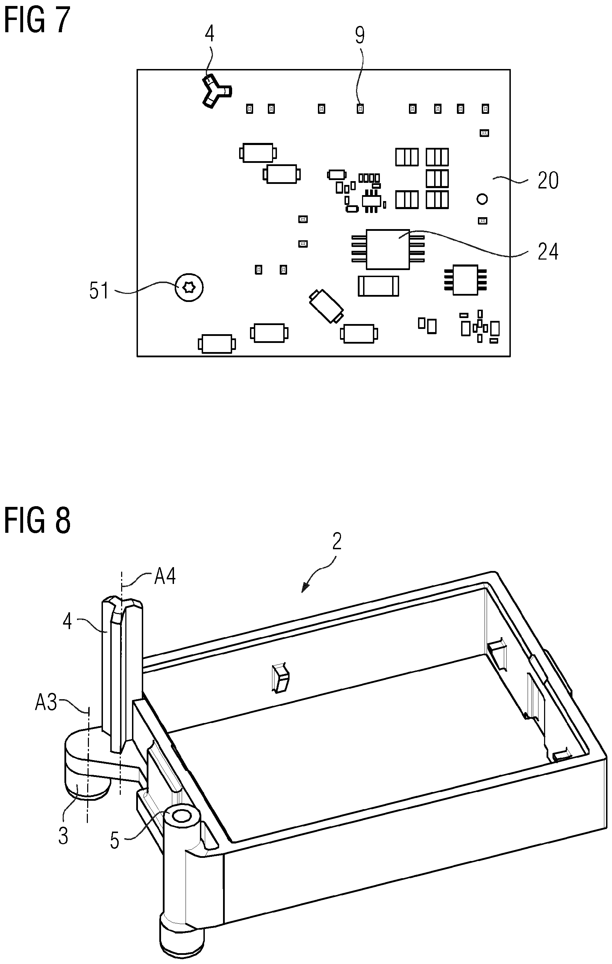

FIG 7 zeigt das Leistungsmodul, welches mit einer Ansteuerungseinheit verbunden ist, aus der Vogelperspektive,

FIG 5 zeigt zudem eine Mehrzahl an elektronischen Bauelementen 24.

Ein elektronische Bauelement 24 ist beispielsweise ein Kondensator, ein Widerstand oder eine Diode. Es sind auch andere Bauelemente möglich. Die elektronischen Bauelemente 24 dienen vorzugsweise einer Ansteuerung.

Der zweite vorstehende Abschnitt 4 greift in der Figur in eine Öffnung 20 der Ansteuerungseinheit ein. Dies ermöglicht eine gute Zentrierung.

Die Figur zeigt zudem eine Kühlkörperabdeckung bzw. einen Halterahmen 23.

FIG 5 zeigt ein Fixierungselement 5.

Dies dient einer Fixierung der Ansteuerungseinheit 20. Das Fixierungselement ist vorteilhaft derart ausgebildet, dass die Ansteuerungseinheit gestützt wird.

Ferner weist das Fixierungselement 5 vorteilhaft einen Hohlraum auf, in welchem beispielsweise ein Gewinde ausgebildet ist. Dies bietet den Vorteil, dass mittels einer Schraube 51, die Ansteuerungseinheit 5 fixiert werden kann.

Das Fixierungselement ist vorteilhaft eine Vorrichtung, die zu einer kraftschlüssigen Verbindung und/oder formschlüssigen Verbindung mit einem weiteren Körper ausgebildet ist.

Das Fixierungselement ist beispielsweise eine Vorrichtung mit einem Innengewinde, die zur Aufnahme eines Körpers mit einem Außengewinde, z. B. eine Schraube, ausgebildet ist.

Eine Lösbarkeit ist durch eine Schraube gewährleistet. Daher wird diese Ausführungsform bevorzugt.

Ferner ist es möglich, dass das Fixierungselement 5 einen Hohlraum aufweist, dergestalt, dass eine gewindefurchende bzw. gewindeschneidende Schraube befestigbar ist.

Das Fixierungselement kann, wie in der Figur gezeigt, auch einen ersten vorstehenden Abschnitt 3 aufweisen.

Das Leistungsmodul 10 ist vorzugsweise Teil eines Umrichtersystems. Das Umrichtersystem ist vorzugsweise hochperformant und eignet sich besonders gut für einen Antrieb von Produktions- und Werkzeugmaschinen sowie in der Glas- und/oder Verpackungsindustrie. Weitere Anwendungsgebiete sind Heating, Ventilation, Air-Conditioning, Pumpen und Standard-Lüfter sowie verschiedene Umrichteranwendungen.

Die Erfindung bietet den Vorteil, dass Prozess-, Montage- und Fertigungsschritte vereinfacht werden und Kosten, insbesondere im Hinblick auf eingesetztes Material, reduziert werden können. Für die beschriebene Vorrichtung muss wesentlich weniger Material verwendet werden als für ein bisher übliches Gehäuse.

Der Stromrichter wird dadurch auch leichter.

Anstatt eine eingehauste Leistungseinheit auf dem Kühlkörper zu verschrauben und hierzu Buchsen im Gehäuse einzusetzen, wird die beschriebene Vorrichtung vorteilhaft direkt auf dem Kühlkörper angebracht.

Zur einfacheren Positionierung und der Sicherstellung gegen Verdrehen sind vorteilhaft mindestens zwei Zapfen vorgesehen, die nur in ein zur Positionierung minimal tiefes Loch, vorzugsweise Sackloch, eintauchen. Vorzugsweise beträgt die Tiefe 1 mm bis 5 mm.

Der Kühlkörper 8 samt Leistungseinheit 11 wird vorteilhaft mittels des wenigstens einen Positionierzapfens in einer Funktion als Positionierwerkzeug in die Hauptplatine geführt und so eine Positionierung ermöglicht.

Mittels der Schraube 51 am Fixierelement wird vorteilhaft eine durchgängige mechanische Verbindung vom Kühlkörper 8 zur Hauptplatine geschaffen. Mit dieser Verbindung ist zusätzlich eine direkte Ausrichtung dieser Bauteile durch den Positionierzapfen gestaltet. Dies fördert eine bessere konstruktive Abstimmung der Bauteile.

FIG 6 zeigt einen Stromrichter 30.

Der Stromrichter 30 weist wenigstens ein Leistungsmodul 10 auf, welches bereits beschrieben wurde. Der Stromrichter kann auch eine Mehrzahl an Leistungsmodulen 10 aufweisen.

Der Stromrichter weist zudem eine wenigstens ein elektronisches Bauelement 24 aufweisende Ansteuerungseinheit 20 auf.

Das Leistungsmodul 10 und die Ansteuerungseinheit 20 sind, wie in der Figur gezeigt, miteinander verbunden.

FIG 8 zeigt den Rahmen 2.

Der gezeigte Rahmen weist wenigstens einen ersten vorstehenden Abschnitt 3 auf, wobei der erste vorstehende Abschnitt 3 dazu ausgebildet ist, in eine Vertiefung oder eine Öffnung 12 des Kühlkörpers 8 einzugreifen.

Der Rahmen 2 weist in der Figur ferner genau einen zweiten vorstehenden Abschnitt 4 auf, wobei der zweite vorstehende Abschnitt 4 zum Eingriff in eine Vertiefung oder eine Öffnung oder eine Einkerbung 21 einer wenigstens ein elektronisches Bauelement 24 aufweisenden Ansteuerungseinheit 20 ausgebildet ist. Die Kontur des ersten vorstehenden Abschnitts 3 ist im Querschnitt betrachtet wenigstens im Wesentlichen in Form eines Kreises bzw. rund ausgebildet.

Die Kontur des zweiten vorstehenden Abschnitts 4 ist im Querschnitt betrachtet wenigstens im Wesentlichen in Form eines Sterns ausgebildet, wobei der Stern drei Schenkel aufweist.

Die Figur zeigt zudem die Längsachsen A3 und A4. Die beiden Abschnitte 3 und 4 liegen nicht auf einer gemeinsamen Längsachse. Die beiden Abschnitte 3 und 4 liegen auf unterschiedlichen Längsachsen A3 und A4.

FIG 9 zeigt die Kontur des zweiten vorstehenden Abschnitts 4 im Detail.

Die Enden der Schenkel S1, S2 und S3 weisen eine Rundung auf, welche gemäß einer gedachten Rundung R2 ausgebildet ist. R2 ist in der Figur ein Kreis.

Die Rundung R2 ist ein Maß für den zweiten vorstehenden Abschnitt 4 (auch Y-Zapfen oder Y-Körper genannt). R2 kann einem runden Zapfen mit dem gleichen Durchmesser wie der zweite Y-Körper entsprechend angesehen werden.

Die Rundung R1 entspricht beispielsweise eine Bohrung bzw. Öffnung der Ansteuerungseinheit. Diese ist vorzugsweise etwas größer als die Rundung R2.

Werden die beiden Zapfenvarianten horizontal verschoben, kontaktiert eine Y-Kontur diese Bohrung später als eine Runde. Dargestellt ist die Berührung der Kanten der Y-Schenkel mit der Bohrung und links davon ist die außerhalb liegende runde Kontur ersichtlich. Dies hat den Vorteil, dass durch die gezeigte Y-Kontur mehr Spielraum besteht, bis eine Kollision eintritt als bei einer runden Kontur.

## Patentansprüche

1. Leistungsmodul (10), aufweisend:
- wenigstens einen Kühlkörper (8),
- wenigstens eine Leistungseinheit (11), wobei die Leistungseinheit (11) wenigstens ein Halbleiterbauelement (6) und ein Substrat (7) umfasst,
- eine Vorrichtung (1) zur Einfassung der wenigstens teilweise innerhalb und/oder auf dem Kühlkörper (8) ausgebildeten Leistungseinheit (11) und zur Zentrierung einer Ansteuerungseinheit (20) bezüglich der Leistungseinheit (11), wobei die Vorrichtung (1) umfasst:
- einen Rahmen (2), wobei der Rahmen (2) das Substrat (7) wenigstens teilweise, vorzugsweise vollständig, umgibt,
- wenigstens einen ersten vorstehenden Abschnitt (3), wobei der erste vorstehende Abschnitt (3) in eine Vertiefung oder eine Öffnung (12) des Kühlkörpers (8) eingreift,
- wenigstens einen zweiten vorstehenden Abschnitt (4), wobei der zweite vorstehende Abschnitt (4) zum Eingriff in eine Vertiefung oder eine Öffnung oder eine Einkerbung (21) einer wenigstens ein elektronisches Bauelement (24) aufweisenden Ansteuerungseinheit (20) ausgebildet ist,
**dadurch gekennzeichnet, dass**
eine Kontur des zweiten vorstehenden Abschnitts (4) im Querschnitt betrachtet wenigstens im Wesentlichen in Form eines Sterns ausgebildet ist, wobei der Stern wenigstens einen ersten Schenkel, einen zweiten Schenkel und einen dritten Schenkel aufweist.

2. Leistungsmodul (10) nach Anspruch 1, wobei eine Kontur des ersten vorstehenden Abschnitts (3) im Querschnitt betrachtet wenigstens im Wesentlichen in Form eines Kreises ausgebildet ist, wobei der erste Schenkel und der zweite Schenkel derart angeordnet sind, dass sie aus einer Vogelperspektive betrachtet die Kontur des ersten Abschnitts (3) teilweise umgeben.

3. Leistungsmodul (10) nach einem der vorhergehenden Ansprüche, wobei eine Länge des ersten Schenkels einer Länge des zweiten Schenkels entspricht.

4. Leistungsmodul (10) nach einem der vorhergehenden Ansprüche, wobei der erste Schenkel länger ist als der dritte Schenkel.

5. Leistungsmodul (10) nach einem der vorhergehenden Ansprüche, wobei der Rahmen (2) auf dem Kühlkörper (8) mittels Klebung fixiert ist.

6. Leistungsmodul (10) nach einem der vorhergehenden Ansprüche, wobei der Rahmen (2) rechteckig ausgebildet ist, wobei der erste vorstehende Abschnitt (3) wenigstens im Wesentlichen an einer Ecke, insbesondere Außenecke, des Rahmens (2) angeordnet ist, wobei der zweite vorstehende Abschnitt (4) wenigstens im Wesentlichen an einer Ecke, insbesondere Außenecke, des Rahmens (2) angeordnet ist.

7. Leistungsmodul (10) nach einem der vorhergehenden Ansprüche, wobei der erste vorstehende Abschnitt (3) und der zweite vorstehende Abschnitt (4) in gegensätzliche Richtungen ragend ausgebildet sind.

8. Leistungsmodul (10) nach einem der vorhergehenden Ansprüche, wobei der erste vorstehende Abschnitt (3) und der zweite vorstehende Abschnitt (4) senkrecht zu einer Oberfläche (82) des Kühlkörpers (8) ausgerichtet sind.

9. Leistungsmodul (10) nach einem der vorhergehenden Ansprüche, wobei der Rahmen (2) Polyphenylensulfid aufweist.

10. Leistungsmodul (10) nach einem der vorhergehenden Ansprüche, wobei ein Winkel zwischen dem ersten Schenkel und dem zweiten Schenkel einem Winkel zwischen dem zweiten Schenkel und dem dritten Schenkel gleicht.

11. Leistungsmodul (10) nach einem der vorhergehenden Ansprüche, wobei ein Schenkel ein Breite aufweist, die zwischen 0,5 mm und 2 mm, vorzugsweise zwischen 0,8 mm und 1,6 mm, insbesondere zwischen 1,1 mm und 1,3 mm, liegt.

12. Leistungsmodul (10) nach einem der vorhergehenden Ansprüche, ferner aufweisend ein Fixierungselement (5) zur Fixierung der Ansteuerungseinheit (20).

13. Rahmen (2) für ein Leistungsmodul (10) nach einem der vorhergehenden Ansprüche, aufweisend:
- wenigstens einen ersten vorstehenden Abschnitt (3), wobei der erste vorstehende Abschnitt (3) zum Eingriff in eine Vertiefung oder eine Öffnung (12) eines Kühlkörpers (8) ausgebildet ist,
- wenigstens einen zweiten vorstehenden Abschnitt (4), wobei der zweite vorstehende Abschnitt (4) zum Eingriff in eine Vertiefung oder eine Öffnung (21) einer wenigstens ein elektronisches Bauelement (24) aufweisenden Ansteuerungseinheit (20) ausgebildet ist,
wobei eine Kontur des zweiten vorstehenden Abschnitts (4) im Querschnitt betrachtet wenigstens im Wesentlichen in Form eines Sterns ausgebildet ist, wobei der Stern wenigstens drei Schenkel aufweist.

14. Stromrichter (30), aufweisend:
- ein Leistungsmodul (10) nach einem der Ansprüche 1 bis 12,
- eine wenigstens ein elektronisches Bauelement (24) aufweisende Ansteuerungseinheit (20),
wobei das Leistungsmodul (10) und die Ansteuerungseinheit (20) miteinander verbunden sind.

15. Stromrichter (30) nach Anspruch 14, wobei die Ansteuerungseinheit (20) bezüglich des Leistungsmoduls (10) durch einen Eingriff des zweiten vorstehenden Abschnitts (4) des Leistungsmoduls (10) in eine Vertiefung oder eine Öffnung (21) der Ansteuerungseinheit (20) zentriert ist.

## Claims

1. Power module (10), having:
- at least one heat sink (8),
- at least one power unit (11), wherein the power unit (11) comprises at least one semiconductor element (6) and a substrate (7),
- a device (1) for enclosing the power unit (11) formed at least partially inside and/or on the heat sink (8) and for centring a control unit (20) with respect to the power unit (11), wherein the device (1) comprises:
- a frame (2), wherein the frame (2) surrounds the substrate (7) at least partially, preferably completely,
- at least one first projecting section (3), wherein the first projecting section (3) engages in a recess or an opening (12) of the heat sink (8),
- at least one second projecting section (4), wherein the second projecting section (4) is designed to engage in a recess or an opening or a notch (21) of a control unit (20) having at least one electronic component (24),
**characterised in that** an outline of the second projecting section (4) is at least essentially star-shaped when viewed in cross-section, wherein the star has at least a first leg, a second leg and a third leg.

2. Power module (10) according to claim 1, wherein an outline of the first projecting section (3) is at least essentially circular in shape when viewed in cross-section, wherein the first leg and the second leg are disposed such that they partially surround the outline of the first section (3) when viewed from a bird's eye perspective.

3. Power module (10) according to one of the preceding claims, wherein a length of the first leg corresponds to a length of the second leg.

4. Power module (10) according to one of the preceding claims, wherein the first leg is longer than the third leg.

5. Power module (10) according to one of the preceding claims, wherein the frame (2) is fixed to the heat sink (8) by means of adhesive.

6. Power module (10) according to one of the preceding claims, wherein the frame (2) is rectangular, wherein the first projecting section (3) is at least essentially disposed at a corner, in particular an outer corner, of the frame (2), wherein the second projecting section (4) is at least essentially disposed at a corner, in particular an outer corner, of the frame (2).

7. Power module (10) according to one of the preceding claims, wherein the first projecting section (3) and the second projecting section (4) project in opposite directions.

8. Power module (10) according to one of the preceding claims, wherein the first projecting section (3) and the second projecting section (4) are oriented perpendicular to a surface (82) of the heat sink (8).

9. Power module (10) according to one of the preceding claims, wherein the frame (2) features polyphenylene sulfide.

10. Power module (10) according to one of the preceding claims, wherein an angle between the first leg and the second leg is equal to an angle between the second leg and the third leg.

11. Power module (10) according to one of the preceding claims, wherein a leg has a width of between 0.5 and 2 mm, preferably between 0.8 and 1.6 mm, in particular between 1.1 and 1.3 mm.

12. Power module (10) according to one of the preceding claims, additionally having a fixing element (5) for fixing the control unit (20).

13. Frame (2) for a power module (10) according to one of the preceding claims, having:
- at least one first projecting section (3), wherein the first projecting section (3) is designed to engage in a recess or opening (12) of a heat sink (8),
- at least one second projecting section (4), wherein the second projecting section (4) is designed to engage in a recess or opening (21) of a control unit (20) having at least one electronic component (24),
wherein the outline of the second projecting section (4) is at least essentially star-shaped when viewed in cross-section, wherein the star has at least three legs.

14. Power converter (30), having:
- a power module (10) according to one of claims 1 to 12,
- a control unit (20) having at least one electronic component (24),
wherein the power module (10) and the control unit (20) are interconnected.

15. Power converter (30) according to claim 14, wherein the control unit (20) is centred with respect to the power module (10) by engagement of the second projecting section (4) of the power module (10) in a recess or opening (21) of the control unit (20).

## Revendications

1. Module (10) de puissance, comportant :
- au moins un refroidisseur (8),
- au moins une unité (11) de puissance, l'unité (11) de puissance comprenant au moins un composant (6) à semiconducteur et un substrat (7),
- un dispositif (1) pour border l'unité (11) de puissance constituée au moins en partie à l'intérieur et/ou sur le refroidisseur (8) et pour centrer une unité (20) de commande par rapport à l'unité (11) de puissance, dans lequel le dispositif (1) comprend :
- un cadre (2), le cadre (2) entourant le substrat (7) au moins en partie, de préférence complètement,
- au moins une première partie (3) en saillie, dans lequel la première partie (3) en saillie pénètre dans une cavité ou une ouverture (12) du refroidisseur (8),
- au moins une deuxième partie (4) en saillie, dans lequel la deuxième partie (4) en saillie est constituée pour pénétrer dans une cavité ou une ouverture ou une encoche (21) d'une unité (20) de commande ayant au moins un composant (24) électronique, **caractérisé en ce qu'**
un contour de la deuxième partie (4) en saillie est, considéré en section transversale, constitué au moins sensiblement sous la forme d'une étoile, dans lequel l'étoile a au moins une première branche, une deuxième branche et une troisième branche.

2. Module (10) de puissance suivant la revendication 1, dans lequel un contour de la première partie (3) en saillie est, considéré en section transversale, constitué au moins sensiblement sous la forme d'un cercle, dans lequel la première branche et la deuxième branche sont disposées de manière à ce qu'elles entourent, considéré suivant une vue de dessus, partiellement le contour de la première partie (3).

3. Module (10) de puissance suivant l'une des revendications précédentes, dans lequel une longueur de la première branche correspond à une longueur de la deuxième branche.

4. Module (10) de puissance suivant l'une des revendications précédentes, dans lequel la première branche est plus longue que la troisième branche.

5. Module (10) de puissance suivant l'une des revendications précédentes, dans lequel le cadre (2) est fixé au refroidisseur (8) au moyen d'un collage.

6. Module (10) de puissance suivant l'une des revendications précédentes, dans lequel le cadre (2) est constitué de manière rectangulaire, dans lequel la première partie (3) en saillie est disposée au moins sensiblement à un sommet, en particulier à un sommet extérieur, du cadre (2), dans lequel la deuxième partie (4) en saillie est disposée au moins sensiblement à un sommet, en particulier à un sommet extérieur, du cadre (2).

7. Module (10) de puissance suivant l'une des revendications précédentes, dans lequel la première partie (3) en saillie et la deuxième partie (4) en saillie sont constituées de manière à faire saillie dans des sens contraires.

8. Module (10) de puissance suivant l'une des revendications précédentes, dans lequel la première partie (3) en saillie et la deuxième partie (4) en saillie sont dirigées perpendiculairement à une surface (82) du refroidisseur (8).

9. Module (10) de puissance suivant l'une des revendications précédentes, dans lequel le cadre (2) a du poly (sulfure de phénylène) .

10. Module (10) de puissance suivant l'une des revendications précédentes, dans lequel un angle entre la première branche et la deuxième branche est égal à un angle entre la deuxième branche et la troisième branche.

11. Module (10) de puissance suivant l'une des revendications précédentes, dans lequel une branche a une largeur, qui est comprise entre 0,5 mm et 2 mm, de préférence entre 0,8 et 1,6 mm, en particulier entre 1,1 mm et 1,3 mm.

12. Module (10) de puissance suivant l'une des revendications précédentes, comprenant en outre un élément (5) de fixation pour la fixation de l'unité (20) de commande.

13. Cadre (2) d'un module (10) de puissance suivant l'une des revendications précédentes, comportant :
- au moins une première partie (3) en saillie, la première partie (3) en saillie étant constituée pour pénétrer dans une cavité ou une ouverture (12) d'un refroidisseur (8),
- au moins une deuxième partie (4) en saillie, la deuxième partie (4) en saillie étant constitué pour pénétrer dans une cavité ou une ouverture (21) d'une unité (20) de commande ayant au moins un composant (24) électronique,
dans lequel un contour de la deuxième partie (4) en saillie est, considéré en section transversale, constitué au moins sensiblement sous la forme d'une étoile, l'étoile ayant au moins trois branches.

14. Redresseur (30), comportant :
- un module (10) de puissance suivant l'une des revendications 1 à 12,
- au moins une unité (20) de commande ayant un composant (24) électronique,
dans lequel le module (10) de puissance et l'unité (20) de commande sont connectés l'un à l'autre.

15. Redresseur (30) suivant la revendication 14, dans lequel l'unité (20) de commande est centrée par rapport au module (10) de puissance par une pénétration de la deuxième partie (4) en saillie du module (10) de puissance dans une cavité ou une ouverture (21) de l'unité (20) de commande.
